# EUROPEAN PATENT SPECIFICATION

(11) **EP 2 767 610 B1**
(45) Date of publication and mention of the grant of the patent: **30.12.2015**
(21) Application number: 13155587.2
(22) Date of filing: 18.02.2013
(51) Int. Cl.: C23C 14/34, C04B 35/453, C04B 35/626

(54) **ZnO-Al2O3-MgO sputtering target and method for the production thereof**
Sputtertarget aus ZnO-Al2O3-MgO und Verfahren zur Herstellung desselben
Cible de pulvérisation ZnO-Al2O3-MgO et son procédé de production

(43) Date of publication of application: 20.08.2014
(73) Proprietor: Heraeus Deutschland GmbH & Co. KG, 63450 Hanau (DE)
(72) Inventor: Herzog, Andreas, Dr., 63486 Bruchköbel (DE); Simons, Christoph, Dr., 63599 Biebergemünd (DE)
(74) Representative: Staudt, Armin Walter

(56) References cited:
- EP-A1- 2 514 851
- US-A1- 2007 071 985
- US-A1- 2009 101 493
- US-A1- 2012 153 237

## Description

### Technical Field

The present invention relates to a ZnO-Al₂O₃-MgO sputtering target. In the following such material is also referred to as ZAMO.

Furthermore, the invention refers to a method for producing a ZnO-Al₂O₃-MgO sputtering target comprising comprising the steps of mixing powders of raw material components comprising Al₂O₃, ZnO and MgO or precursors of these substances and sintering the powder mixture so as to obtain the sputtering target, whereby the step of mixing comprises a mixing of powders of the raw material components in a liquid.

### Prior art

EP 1 887 100 B1 describes a ZAMO material and its production. The material is obtained by dry mixing single oxides on a powder metallurgical way. It is proposed to precalcine mixtures of two single oxides at 1000°C and add the third oxide press-shape finally, and subsequently sintering the target.

The mayor disadvantages of such method are inhomogeneous oxide distributions and certain amounts of single phases of Al₂O₃ and MgO. The dry mixing in a ball mill is applied sometimes even twice and will cause significant amounts of impurity originating of the milling media.

This makes a pure target with 3N quality or better impossible and has severe consequences for layer properties, especially translucency. Electrical resistance is at least 30 mOhm·cm, e.g. 35 mOhm·cm for the example ZAMO 88/1.5/10.5 at%.

The alternative method by producing a ceramic ZnO-Al₂O₃-MgO (ZAMO) with small grain sizes via water based slurry and wet milling causes problems due to solubility of Mg²⁺ ions dissolved from the MgO. These Mg²⁺ ions destabilise the electric double layer surrounding each particle. Therefore a good deflocculating of single oxide particles the slurry cannot be achieved.

This problem can be avoided by a method for producing a sputtering target of Al-Mg-Ga-Zn oxide as it is disclosed in EP 2 514 851 A1. The preparation of the sputtering target comprises wet milling of oxide starting powders in ethanol to a mean particle size < 0.4 microns, drying the powder and hot pressing in a graphite mold under vacuum. The resulting sputtering targets have an electrical resistance of 6 mOhm·cm, respectively 2 mOhm·cm. The portion of Ga₂O₃ is below 0.1 wt-% but this low content is sufficient to obtain a transparent film from the sputtering target, which after heating in a humid atmosphere retains its low electrical resistivity.

US 2009/101493 A1 D2 discloses a sputtering target of Mg-Zn oxide which may additionally contain gallium oxide and/or aluminum oxide. The portion of Mg is 2-30 at.-% and that of Ga₂O₃/Al₂O₃ from 3.2 to 6.5 at.-%. The target material is prepared by a sintering process. The starting powder is very finely ground (< 1µm) and processed together with a binder into granules, which are then pressed into shaped bodies and sintered. The resulting target material consists of a complete solid solution of Al/Ga and Mg in ZnO. In a XRD diagram neither an MgO phase nor a mixed phase MgAl₂O₄ can be found. The electrical resistance of the target material is about 1 mOhm.cm.

US 2012/0153237 A1 describes a varistor composition based on ZnO and additional components in the form of Ca- and Mg-containing compounds, which shall be suitable to reduce the dielectric constant of the varistor material. It is mentioned, that the Mg-containing additive is MgO or MgCO₃. Both compounds show high solubility in ZnO crystal matrix so that a solid solution with ZnO can be obtained.

### Technical objective

However perfect deflocculating is a prerequisite for well dispersed oxide mixtures as well in milling processes which is demanded in the case of ZAMO. This is to guarantee homogenous oxide distribution.

Therefore, smooth sputter behaviour by avoiding single inclusions of single nonconductive oxides is aspired, especially if even more strict demands for producing homogenous optical layers from such sputtering target shall be met. The enrichments of single oxides in a sputter target are disadvantageous since arcing, preferential sputtering and inhomogeneous sputter layer can be the consequence.

Therefore, it is an object of the present invention to provide a target with high purity having 3N quality or better and which is suitable to produce homogenous optical layers fulfilling high quality demands.

Furthermore, it is an object of the invention to provide a method which is suitable for the inexpensive manufacturing of sputtering targets.

### General description of the invention

By starting from the aforementioned method this object is achieved according to the invention with respect to the method, in that in that the maximum solubility for said raw material powders in said liquid is less than 200 mg/kg and whereby said liquid comprises water, and powder of MgCO₃ is used as a precursor component for MgO.

According to the method a wet mixing of the component powders is proposed. In a wet mixing process less impurity is released from the mixing devices so that a high purity of the final product can be maintained. In order to avoid negative effects on deflocculating caused by electrical charged ions of any of the components dissolved in the liquid, a liquid is used in which the raw material powders have low solubility. Low solubility in this respect means a solubility of the component which is as low as possible; that means here that the dissolved solid content of the raw material components is less than 200 mg in kg liter of said liquid.

After drying the well mixed oxides of the slurry are supporting the formation of solid solutions between single oxides during sintering due to shorter diffusion paths. Further enrichment of single elements or oxides in the bulk is avoided by a well distributed starting mixture.

A target is obtained comprising minimal amounts of single phase oxides. Such single phase oxides are negatively affecting the homogeneity of the target and consequently of the sputtering homogeneity. The microstructure is essentially composed of ZnO and ternary and binary oxides. It contains no single component oxide phase consisting of either Al₂O₃ or of MgO or it contains such single component oxide phases in an amount of less than 1 % per weight.

The liquid used in the mixing step comprises water and powder of MgCO₃ is used as a precursor component for MgO. MgCO₃ has a low solubility in water compared to MgO. The specific maximum solubility of MgCO₃ in 1 kg distillated water is less than 200 mg.

MgCO₃ is a precursor material of MgO. In a calcination step prior to sintering MgCO₃ is oxidized forming MgO.

In a preferred modification of the method the mixing in the liquid comprises a wet milling process, whereby the wet mixing results in fine powders of the raw material components having particle medium particle sizes (d₉₀ value) of less than 10 µm, preferably less than 5 µm.

Due to the small particle size, said powder has a high surface so that a high sinter activity of the powder mixture is achieved requiring temperatures for sintering which are lower than in the case of less sinter active powder mixtures. The lower sintering temperature avoids excess grain growth during sintering and helps minimize the amount of oxide phase regions consisting of MgO or Al₂O₃.

In a preferred modification of the method a raw material powder is provided within the following composition ranges (in wt.%):

| | | | |
|---|---|---|---|
| Al₂O₃: | 0,5-5, | preferably | 2-4 |
| MgO: | 0,5-15, | preferably | 3-9 (balance = ZnO). |

With respect to the ZnO-Al₂O₃-MgO sputtering target, the aforementioned object is achieved according to the invention in that it comprises a microstructure composed of ZnO and ternary and binary oxides but containing single component oxide phase consisting of either Al₂O₃ or of MgO in an amount of less than 1 % per weight whereby the microstructure contains regions of single and binary phases of zincite, gahnite (ZnAlO₄) and spinel (MgAlO₄).

In the ideal case, the microstructure of the target material completely consists of ZnO and of binary or ternary oxides each forming a solid solution of several elements. In practice, a certain amount of MgO or Al₂O₃ may be contained even if it is below detection limit of x-ray diffraction. An elemental analysis results in a homogeneous distribution of Zn, Al, Mg and oxygen.

The target of the invention has a fine grained structure with homogeneous distribution of the elements belonging to ZnO-Al₂O₃-MgO in the bulk material.

However, it contains several crystalline phases. Commonly, e.g. in the prior art mentioned above, a solid solution without such crystalline binary or ternary phases is wanted. In contrast to this, the microstructure of the sputtering target contains regions of single and binary phases of zincite, gahnite (ZnAlO₄) and spinel (MgAlO₄), whereby, preferably, the regions of gahnite phases have lateral dimensions smaller than 5 µm and the regions of spinel phases have lateral dimensions smaller than 1 µm. The lateral dimensions are medium values.

It was found that said zincite, gahnite (ZnAlO₄) and spinel (MgAlO₄) regions are a result of using relative coarse starting grains. Coarse grain requires relatively less time and energy for milling and it contains less impurity caused by wear and abrasion. Surprisingly, it was found that the multi-crystalline structure works very well. It was shown that instead of seeking an expensive solid-solution crystalline phase a much cheaper structure using coarser powders or shorter milling is also successful.

Said target is obtainable by the method of the invention as described above.

In a preferred modification of the sputtering target it is characterized by a composition ZnO 92 / Al₂O₃ 3 / MgO 5 (in wt.%).

Besides negligible amounts below detection limit, this material contains no single component oxide phases consisting of either Al₂O₃ or of MgO but the microstructure almost consists of ZnO and of binary or ternary oxides each forming a solid solution of several elements.

In another preferred modification of the sputtering target the microstructure has a medium crystallite size below 5000 Angstrom preferably below 2000 Angstrom..

The crystallite size is measured by x-ray diffraction.. A small medium crystallite size in the sputtering target is result especially of a wet mixing process of the raw material. A fine grained microstructure gives better results in sputtering homogeneity.

In a preferred modification of the sputtering target the electrical resistivity of the target is less than 50 mOhm·cm, preferably less than 30 mOhm·cm.

In a preferred modification of the sputtering target it is made in form of tiles having a tile size larger than 100 cm², preferably larger than 200 cm².

This is a relative large tile size which can be achieved by using the claimed method. Therefore, the number of bond gaps in the target can be reduced.

### Preferred embodiments

The invention will now be explained in more detail with reference to embodiments and a drawing, in which shows:
- **Fig. 1**: a diagram showing the particle size distribution of a slurry after finsihing of the wet milling process,
- **Fig. 2**: a diagram showing micro-arcing of a sputter target cathode (PK 500) made of ZAMO material produced by either by a dry mixing method according to the prior art and by a wet mixing process according to the invention,
- **Fig. 3**: a photo of a cross-section polish showing of a ZAMO material according to the invention after sintering (showing agglomerates and phases),
- **Fig. 4**: a photo of a cross-section polish of a ZAMO material according to the invention after sintering and subsequent thermal etching (showing grain sizes), and
- **Fig. 5**: an XRD diagram of a ZAMO material according to the invention showing the occurrence of crystalline phases consisting of zincite, gahnite and spinel.

### Example 1

A mixture of ZnO (86 wt.%), Al₂O₃ (3 wt.%) and MgCO₃ (11 wt.%;) in water was prepared. A Na+ containing dispersant was added in order to stabilize the slurry and to increase solid loading of the slurry, which was 55 wt.%.

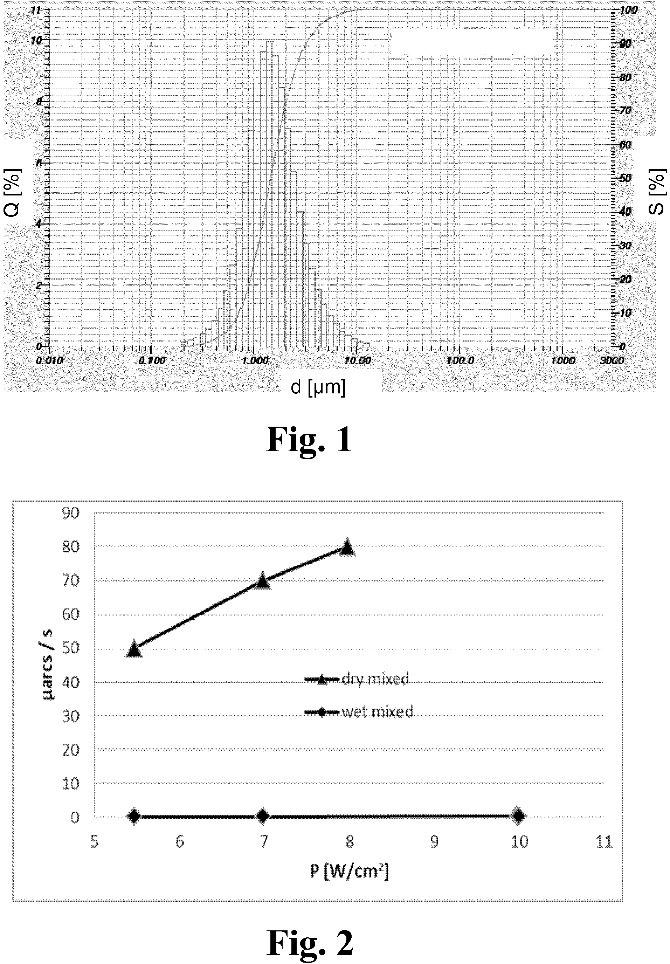

The slurry was treated with a high energy ball mill using milling balls of ZrO₂, and diameter 1 mm. During milling energy of 0.025 kWh/kg slurry was applied. After milling a particle size measurement of the slurry showed a d10 value less than 1 µm and a d90 value less than 4 µm (see **Fig. 1**). The left ordinate axis in the diagram of Fig. 1 represents the amount Q [in %]. The right ordinate gives the total sum S [in %] and the x-axis represents the particle size d in [µm].

Subsequently, a binder (i.e. PVA) was added and the material was spray dried. Agglomerates and granules of ZAMO were obtained. Said granules have a particle size between 20µm (d10 value) and 60µm (d90 value).

The granules were press shaped at 50 MPa and a tile of 380*150 mm² was achieved. Material was debindered and calcined. Calcination took place in the range up to 700°C by carefully heating with a rate of 5 K/h to avoid high internal gas pressures from CO₂ destroying the shaped green body. Then sintering in ambient atmosphere up to 1400°C was performed.

A density of 5.2 g/cm³ was achieved. Elemental distribution of the elements Zn, Al, Mg, and oxygen was homogeneous and almost no singular phases of insulated Al₂O₃ und MgO in a ZnO based matrix were found. The composition contained 1% spinel, 4% gahnite and 95% zincite.

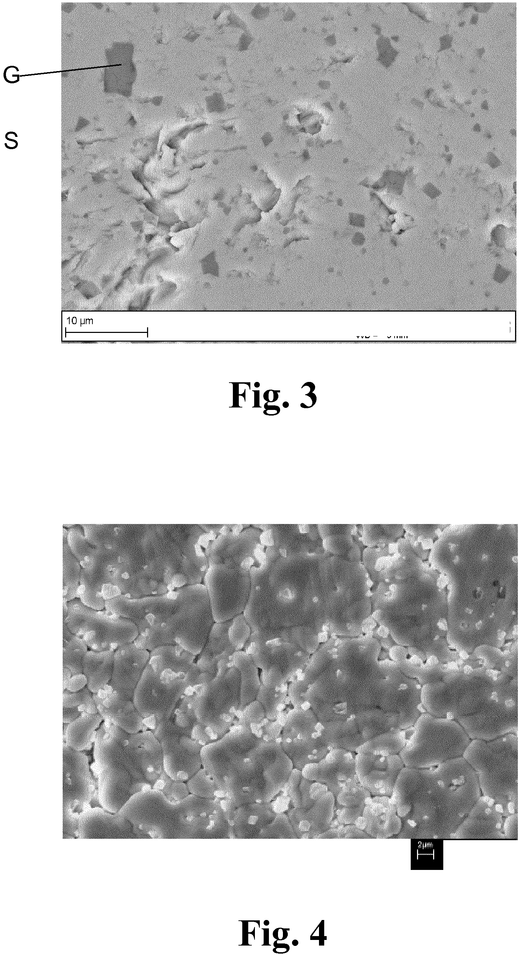

The photo of **Fig. 3** of this material shows agglomerates and phases of gahnite "G" and spinel "S". The photo of **Fig. 4** of this material obtained after etching shows the grain sizes of the microstructure.

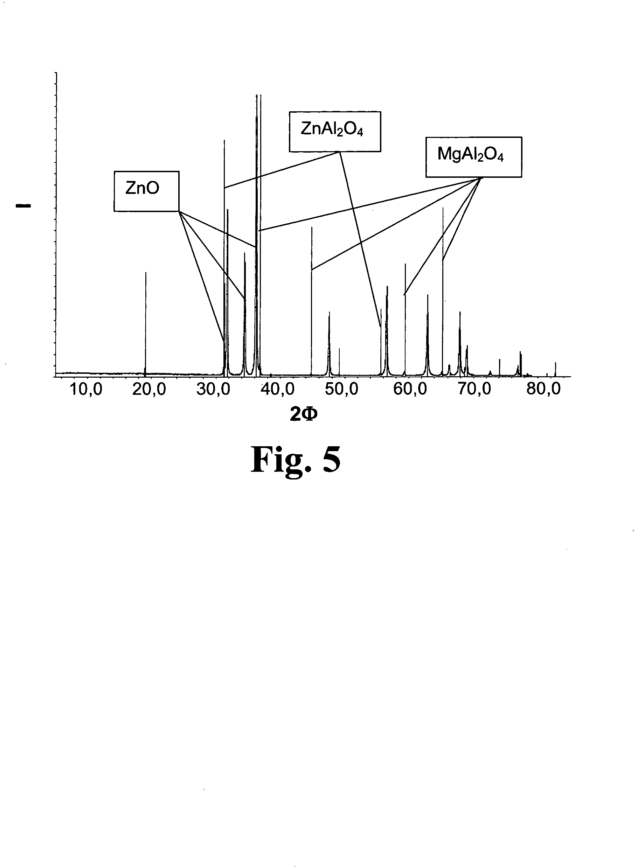

In the XRD analysis diagram of **Fig. 5** the measured defracted intensity I is plotted against diffraction angle 2theta. It shows that the microstructure - within the detection limit - completely consists of ZnO and of binary or ternary oxides, namely gahnite and spinel. Besides ZnO, the diagram shows no line referring to a single component oxide phase consisting of MgO or Al₂O₃.

### Comparative example 1

A mixture of a first powder of ZnO (90 wt.%) + MgO (10 wt.%) and a second powder of Al₂O₃ (50 wt.%) + MgO (50 wt.%) (with particle sizes as example 1) were dry mixed and heat treated up to 1400°C.

X ray analysis of this mixed powder showed no crystalline single component phases of MgO nor Al₂O₃ but only spinel and zincite phase (with solid solution of MgO). The formed mixed powders were mixed with fresh ZnO to give a final composition of ZnO (90 wt.%), Al₂O₃ (3 wt.%) and MgO (6 wt.%) and a slurry of this powder mixtures in water was prepared. A Na+ containing dispersant was added in order to stabilize the slurry and to increase solid loading of the slurry which was 55 wt.%.

Wet milling was applied as described for example 1. Then a binder (i.e. PVA) was added and the material was spray dried. Agglomerates or granules of ZAMO formed having a size between 20µm (d10 value) and 60µm (d90 value).The granules were press shaped at 50 MPa and a tile of 380 mm x 150 mm. Debinding occurred by heating with 10 K/h up to 600 °C and sintering in ambient atmosphere by heating up to 1400°C.

### Comparative Example 2

A dry mixture of ZnO (92 wt.%), Al₂O₃ (3 wt.%) and MgO (5 wt.%) was homogenized in a tubular mixer for 5 h. During the mixing process in parallel milling was applied with a ZrO₂ milling balls, diameter 10 mm which were added to the mixing containment.

It was found that this milling process added 3000 wtppm ZrO₂ impurities in the powder mixture.

The mixture was sieved and press shaped at 50 MPa to a size of 100 x100 mm². Larger tile sizes were impossible to shape since they fractured during handling/pressing.

The process was finished by sintering in ambient atmosphere up to 1450°C.

A density of 4.8 g/cm³ was achieved. Distribution of the elements Zn, AL, Mg, and oxygen was found to be inhomogeneous and singular phases of insulated Al₂O₃ und MgO in a ZnO based matrix were still found. Further the sintered bulk contained porosity in the macroscopic scale.

### Evaluation of quality of sputtering targets and sputtering behaviour

The shaped tiles of example 1 and that of comparative example 1 were machined and grinded and bonded to a backing copper plate. For example 1 obtained by the wet mixing routes according to the invention larger tiles sized 300 x 100 mm² with less bonding gaps per target could be prepared and used.

While the target material obtained by dry mixing route according to comparative example 1 ended up with a tile size 75 x 75 mm², so that consequently the target was composed of multiple segments with a significantly higher amount of bonding gaps.

The targets were examined in a sputtering trail. First the target was ramped up in argon atmosphere. Then slight oxygen of 5 sccm was used for a pre-sputtering procedure. Within 30 min the power was increased up to 5,5 → 7,0 → 10 W/cm². At each power level glass plates (80x30 mm²) were coated. The arcing was examined at the respective different power levels and the result is shown in the diagram of **Fig. 2****.** On the y-axis in the diagram of Fig. 2 the occurrence of micro-arcs per second is plotted against the power P in [W/cm²]

The targets prepared according to the invention (type I) as well as the target prepared by dry mixing of the raw material (type II) show similar sputter rates in the range of 50 nm*m/min.

However, only for the target prepared by dry mixing (type II) hardarcs were observed. At 10W/cm² nearly one hardarc per second was observed.

After sputtering of 36 hours at maximum power level the surface of targets of type I and type II looked significantly different:
Type I: a smooth surface was observed.
Type II: a rough and ragged surface, with pins and dust deposition was achieved.

## Claims

1. A method for producing a ZnO-Al₂O₃-MgO sputtering target, comprising the steps of mixing powders of raw material components comprising Al₂O₃, ZnO and MgO or precursors of these substances and sintering the powder mixtures so as to obtain the sputtering target, said step of mixing comprises a mixing of powders of the raw material components in a liquid, , **characterized in that** the maximum solubility for said raw material powders in said liquid is less than 200 mg/kg and whereby said liquid comprises water, and whereby powder of MgCO₃ is used as a precursor component for MgO.

2. The method of claim 1, **characterized in that** the mixing in the liquid comprises a wet milling process.

3. The method of claim 2, **characterized in that** the wet milling process results in fine powders of the raw material components having medium particle sizes (d₉₀ value) of less than 10 µm, preferably less than 5 µm.

4. The method of any one of the preceding claims, **characterized in that** a raw material powder is provided within the following composition ranges (in wt.%):
| | | | |
|---|---|---|---|
| Al₂O₃: | 0,5-5, | preferably | 2-4 |
| MgO: | 0,5-15, | preferably | 3-9 (balance = ZnO). |

5. A ZnO-Al₂O₃-MgO sputtering target **characterized by** a microstructure containing single component oxide phase consisting of either Al₂O₃ or of MgO in an amount of less than 1 % per weight whereby the microstructure contains regions of single and binary phases of zincite, gahnite (ZnAlO₄) and spinel (MgAlO₄).

6. The ZnO-Al₂O₃-MgO sputtering target of claim 5, **characterized in** a composition ZnO 92 / Al₂O₃ 3/ MgO 5 (in wt.%).

7. The ZnO-Al₂O₃-MgO sputtering target of claim 5, **characterized in that** the regions of gahnite phases have lateral dimensions smaller than 5 µm and the regions of spinel phases have lateral dimensions smaller than 1 µm.

8. The ZnO-Al₂O₃-MgO sputtering target of any one of the preceding claims5 to 7, **characterized in that** the microstructure has medium crystallite size below 5000 Angstrom, preferably below 2000 Angstrom.

9. The ZnO-Al₂O₃-MgO sputtering target of any one of the preceding claims 5 to 8, **characterized in that** the electrical resistivity of the target is less than 50 mOhm·cm, preferably less than 30 mOhm·cm.

10. The ZnO-Al₂O₃-MgO sputtering target of any one of the preceding claims 5 to 9, **characterized in that** it is made in form of tiles having a tile size larger than 100 cm², preferably larger than 200 cm².

## Patentansprüche

1. Verfahren zur Herstellung eines ZnO-Al₂O₃-MgO Sputtertargets, umfassend die Verfahrensschritte des Mischens von Pulvern von Rohstoffkomponenten, die Al₂O₃, ZnO und MgO oder Vorläufersubstanzen davon umfassen, und Sintern der Pulvermischung unter Bildung des Sputter-Targets, wobei der Verfahrensschritt des Mischens ein Mischen der Rohstoffkomponenten-Pulver in einer Flüssigkeit umfasst, **dadurch gekennzeichnet, dass** die maximale Löslichkeit für die Rohstoffkomponenten-Pulver in der Flüssigkeit weniger als 200 mg/kg beträgt, und wobei die Flüssigkeit Wasser enthält, und wobei Pulver aus MgCO₃ als Vorläufersubstanz für MgO eingesetzt wird.

2. Verfahren nach Anspruch 1, **dadurch gekennzeichnet, dass** das Mischen einen Nassmahlprozess umfasst.

3. Verfahren nach Anspruch 2, **dadurch gekennzeichnet, dass** der Nassmahlprozess feine Pulver der Rohstoffkomponenten mit einer mittleren Teilchengröße (d90-Wert) von weniger als 10 µm, vorzugsweise von weniger als 5 µm, ergibt.

4. Verfahren nach einem der vorhergehenden Ansprüche, **dadurch gekennzeichnet, dass** das Rohstoffkomponenten-Pulver innerhalb der folgenden Zusammensetzungsbereiche bereitgestellt wird (in Gew.-%).
| | | | |
|---|---|---|---|
| Al₂O₃: | 0,5-5, | vorzugsweise | 2-4 |
| MgO: | 0,5-15, | vorzugsweise | 3-9 (Rest = ZnO). |

5. ZnO-Al₂O₃-MgO Sputtertarget, **gekennzeichnet durch** eine Mikrostruktur, die Einkomponenten-Oxidphase aus entweder aus Al₂O oder aus MgO in einer Menge von weniger als 1 Gew.-% enthält, wobei die Mikrostruktur Bereiche aus singuläre oder binäre Phasen aus Zinkit, Gahnit (ZnAlO₄) und Spinell (MgAlO₄) enthält.

6. ZnO-Al₂O₃-MgO Sputtertarget nach Anspruch 5 **gekennzeichnet durch** eine Zusammensetzung ZnO 92 / Al₂O₃ 3 / MgO 5 (in Gew.-%)

7. ZnO-Al₂O₃-MgO Sputtertarget nach Anspruch 5, **dadurch gekennzeichnet, dass** die Bereiche der Gahnit Phase laterale Abmessungen von wenige als 5 µm haben und die Bereiche der Spinell-Phase laterale Abmessungen von weniger als 1 µm haben.

8. ZnO-Al₂O₃-MgO Sputtertarget nach einem der vorhergehenden Ansprüche 5 bis 7, **dadurch gekennzeichnet, dass** die Mikrostruktur hat eine mittlere Kristallitgröße von weniger als 5000 Angström aufweist, vorzugsweise weniger als 2000 Angström.

9. ZnO-Al₂O₃-MgO Sputtertarget nach einem der vorhergehenden Ansprüche 5 bis 8, **dadurch gekennzeichnet, dass** sein spezifischer elektrischer Widerstand weniger als 50 mOhm·cm beträgt, vorzugsweise weniger als 30 mOhm·cm.

10. ZnO-Al₂O₃-MgO Sputtertarget nach einem der vorhergehenden Ansprüche 5 bis 9, **dadurch gekennzeichnet, dass** es in Kachelform mit einer Kachelgröße von mehr als 100 cm², vorzugsweise mehr als 200 cm², ausgebildet ist.

## Revendications

1. Procédé pour la production d'une cible de pulvérisation ZnO-Al2O3-MgO comprenant les étapes de mélange de poudres de composants de matière brute Al2O3, ZnO et MgO ou des précurseurs de ces substances et de frittage des mélanges de poudre de manière à obtenir la cible de pulvérisation, ladite étape de mélange comprenant un mélange de poudres de composants de matière brute dans un liquide, **caractérisé en ce que** la solubilité maximale pour lesdites poudres de matière brute dans ledit liquide est inférieure à 200 mg/kg et ledit liquide comprenant de l'eau et la poudre de MgC03 étant utilisé en tant que composant précurseur pour le MgO.

2. Procédé selon la revendication 1, **caractérisé en ce que** le mélange dans le liquide comprend un processus de broyage humide.

3. Procédé selon la revendication 2, **caractérisé en ce que** le processus de mélange humide donne des poudres fines de composants de matière brute ayant des tailles de particules moyennes (valeur d90) inférieures à 10 µm, de préférence inférieure à 5 µm.

4. Procédé selon quelconques des revendications précédentes, **caractérisé en ce qu'**une poudre de matière brute est obtenue dans les compositions suivantes (en % pds) :
| | | | |
|---|---|---|---|
| Al₂O₃ : | 0,5-5, | de préférence | 2-4 |
| MgO : | 0,5-15, | de préférence | 3-9 (équilibre = ZnO). |

5. Cible de pulvérisation ZnO-Al₂O₃-MgO **caractérisé par** une microstructure contenant une phase d'oxyde monocomposant soit d'Al₂O₃ soit de MgO dans une quantité inférieure à 1 % en poids, la microstructure contenant des zones de phase unique et binaire de zincite, gahnite (ZnAlO₄) et de spinelle (MgAlO₄).

6. Cible de pulvérisation ZnO-Al₂O₃-MgO selon la revendication 5, caractérisée dans une composition ZnO 92 / Al₂O₃ 3/MgO 5 (en % pds).

7. Cible de pulvérisation ZnO-Al₂O₃-MgO selon la revendication 5, **caractérisée en ce que** les zones de phases de gahnite présentent des dimensions latérales inférieures à 5 µm et la zone de phases de spinelle des dimensions latérales inférieures à 1 µm.

8. Cible de pulvérisation ZnO-Al₂O₃-MgO selon l'une des revendications 5 à 7, **caractérisée en ce que** la microstructure présente une taille de cristallite moyenne inférieure à 5000 angstrôms, de préférence inférieure à 2000 angströms.

9. Cible de pulvérisation ZnO-Al₂O₃-MgO selon l'une des revendications 5 à 8, **caractérisée en ce que** la résistivité électrique de la cible est inférieure 50 mOhm cm, de préférence inférieure à 30 mOhm cm.

10. Cible de pulvérisation ZnO-Al₂O₃-MgO selon l'une des revendications 5 à 9, **caractérisée en ce qu'**elle est réalisée en forme de tuile de dimensions inférieures à 100 cm², de préférence 200 cm².
